Europäisches Patentamt

European Patent Office

Office européen des brevets

(19)

(11) Veröffentlichungsnummer: **0 259 792 B1**

(12) **EUROPÄISCHE PATENTSCHRIFT**

(45) Veröffentlichungstag der Patentschrift: **26.06.91**

(51) Int. Cl.⁵: **C23C 16/26, C23C 16/02**

(21) Anmeldenummer: **87112918.5**

(22) Anmeldetag: **04.09.87**

(54) Verfahren zur Herstellung von wärmebelasteten Bauelementen mit einer schützenden Schicht.

(30) Priorität: **06.09.86 DE 3630419**

(43) Veröffentlichungstag der Anmeldung:
**16.03.88 Patentblatt 88/11**

(45) Bekanntmachung des Hinweises auf die
Patenterteilung:
**26.06.91 Patentblatt 91/26**

(84) Benannte Vertragsstaaten:
**CH FR GB IT LI SE**

(56) Entgegenhaltungen:
EP-A- 0 142 176
EP-A- 0 183 254
WO-A-86/00093
AU-B- 457 605
DE-A- 3 442 208

NUCLEAR FUSION 25 (1985), Nr. 9, Seiten
1065-1068

PLASMA PHYSICS AND CONTROLLED FU-
SION 28 (1986), Januar, Nr. 1A, Seiten 71-83

JAP. J. APPL. PHYS. 25 (1986), Mai, Nr. 5,
Seiten L 397-L 399

J. OF NUCLEAR MATERIALS, Nr. 128 + 129

(1984), Seiten 841-850

ABSTRACTS OF THE 12th EUROPEAN CON-
FERENCE ON CONTROLLED FUSION AND
PLASMA PHYSICS, Budapest 1985, Seiten
627-630

(73) Patentinhaber: **Forschungszentrum Jülich
GmbH
Postfach 1913
W-5170 Jülich(DE)**

(72) Erfinder: **Winter, Jörg, Dr.
Auestrasse 36
W-5162 Niederzier(DE)**
Erfinder: **Esser, Hans-Günter
Kapellenstrasse 13
W-5172 Linnich-Ederen(DE)**
Erfinder: **Waelbroeck, François, Prof.
Mannheimer Strasse 4
W-5170 Jülich(DE)**
Erfinder: **Wienhold, Peter, Dr.
Rurallee 7
W-5172 Linnich(DE)**

## Beschreibung

Die Erfindung bezieht sich auf ein Verfahren zur Herstellung von Bauelementen, bei dem nach Entfernung der Oberflächenverunreinigungen eine amorphe, wasserstoffhaltige Kohlenstoffschicht aufgetragen wird, auf die von außen durch elektromagnetische Strahlung oder auch Teilchenstrahlung Wärme zugeführt wird.

Einer hohen Wärmebelastung auszusetzende Bauelemente werden beispielsweise in experimentellen Anordnungen benötigt, bei denen es unter anderem darum geht, einen Teilchenstrom oder eine elektromagnetische Strahlung aufzufangen, wobei deren Energie vom Bauteil aufgenommen werden muß. So werden bei Fusionsexperimenten Bauteile eingesetzt, auf welche die das Plasma verlassenden Protonen auftreffen. Wie sich gezeigt hat, werden dabei jedoch Teilchen des Materials der Bauelemente abgetragen und gelangen in das Plasma, wo sie als Verunreinigungen störend wirken. Auf der Conference on Controlled Fusion and Plasma Physics, Budapest, 1985 wurde hierzu berichtet, daß Bauteile aus INCONEL, einer Legierung, die einen Anteil von ca. 2 At% Molybdän enthält, nach einer Reinigung mittels Glimmentladung mit einer wasserstoffhaltigen Schicht von amorphem Kohlenstoff beschichtet und in einem Reaktor getestet wurden.

Es ist Aufgabe der Erfindung, das Verfahren der eingangs bezeichneten Art durch Einsatz geeigneter Materialien für die Bauelemente so zu modifizieren, daß die Bauelemente wenigstens kurzfristig (einige 100 msec) auch eine Strahlungsleistung von 120 MW/m$^2$ unbeschadet überstehen.

Diese Aufgabe wird gemäß der Erfindung dadurch gelöst, daß als Material des Bauelementes Molybdän, Wolfram, Kupfer, Aluminium oder Legierungen auf Basis dieser Metalle verwendet werden und die Kohlenstoffschicht als Schutz gegen kurzzeitige Bestrahlung mit einer Strahlungsleistung von bis zu 120 MW/m$^2$ vorgesehen ist.

Die Teilchenstrahlung kann dabei auch eine Protonenstrahlung sein.

Zur Reduktion der Oberflächenverunreinigungen, d.h. zur Entfernung von Oberflächenverunreinigungen, die mit atomarem Wasserstoff oder niederenergetischen Wasserstoffionen eine Verbindung eingehen, wie beispielsweise Sauerstoff, Kohlenstoff, Chlor, Fluor und Schwefel, wird zweckmäßigerweise nach der aus der DE-AS 26 47 088 bekannten Verfahrensweise vorgegangen, indem die Oberfläche des Bauelementes bei einem Druck von 10$^{-2}$ bis 10$^2$ Pa bei einer Temperatur von 100° C bis 600° C, bevorzugt 300° C, einem Wasserstoffatom-und/oder -ionen enthaltenden Wasserstoffstrom ausgesetzt wird, wobei aus dem Wasserstoffstrom Wasserstoffatome und/oder Wasserstoffionen durch Kontaktdissoziation an heißen Flächen oder mittels Glimmentladung oder durch Elektronenzyklotronresonanz gebildet werden, die mit der Oberfläche des Bauelementes in Kontakt gebracht werden, und wobei die gebildeten flüchtigen Verbindungen abgepumpt werden.

Es kann aber auch zweckmäßig sein, daß das Bauelement zur Reduktion der Oberflächenverunreinigungen unter einem Druck von 10$^{-2}$ bis 10$^2$ Pa und einer Temperatur im Bereich von 10° C bis maximal 100° C einem Wasserstoffatom und/oder -ionen enthaltenden Wasserstoffstrom mit einem Anteil von 0,1 bis 3 Vol% Methan ausgesetzt wird, wobei aus dem Gasstrom Wasserstoffatome und/oder Wasserstoffionen und Kohlenwasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden, und wobei die gebildeten flüchtigen Verbindungen abgepumpt werden. Der als Verunreinigung auf der Oberfläche befindliche Sauerstoff wird dabei bevorzugt in Verbindung mit Kohlenstoff als CO entfernt.

Bei der Durchführung dieser Verfahrensweise können als heiße Fläche beispielsweise Fäden oder Wendeln aus Wolfram, Rhenium oder Tantal eingesetzt werden.

Die Ausrichtung der Wasserstoffatome und/oder -ionen oder auch der Kohlenwasserstoffionen auf die zu reinigende Fläche kann mittels eines elektrischen Feldes erreicht werden oder dadurch, daß eine geeignete Geometrie des Behälters, in welchem sich das Bauelement bei der Reinigung befindet, vorgesehen wird, so daß Atome und/oder Ionen die zu reinigende Oberfläche erreichen.

Hinsichtlich des Abtransports der entstehenden flüchtigen Verbindungen ist dafür Sorge zu tragen. daß eine im Hinblick auf die Entstehungsrate der Verbindungen ausreichende Saugleistung vorgesehen ist, damit erreicht wird, daß die entstehenden Verbindungen abgepumpt werden.

Als zweckmäßig hat sich erwiesen, daß die Stromdichte des auf die Oberfläche gerichteten Atom-bzw. Ionenstroms einige $\mu$A/cm$^2$ bis einige 100 $\mu$A/cm$^2$ beträgt und daß diese Stromdichte wenigstens eine halbe Stunde lang aufrechterhalten wird.

Zur Auftragung der amorphen, wasserstoffhaltigen Kohlenstoffschicht wird die Oberfläche des Bauelementes unter einem Druck von 10$^{-2}$ bis 10$^2$ Pa einem Kohlenwasserstoffionen-Strom ausgesetzt, wobei die Kohlenwasserstoffionen in einer Glimmentladung oder durch Elektronenzyklotronresonanz erzeugt und auf die zu belegende Oberfläche des Bauelementes gerichtet werden.

Die Ausrichtung der Kohlenwasserstoffionen kann dabei durch ein elektrisches Feld erreicht werden oder auch, da eine Energie der Ionen von etwa 10 eV beim Auftreffen auf die Wandung ausreichend ist, durch geeignete Wahl der Geometrie des Behälters, in welchem sich das Bauelement bei der Auftragung der Schicht befindet, so daß die Ionen die Oberfläche des Bauelementes erreichen.

Der in den Behälter eingespeiste Kohlenwasserstoff kann dabei reines Methan sein, jedoch wird zweckmäßigerweise ein Methan-Wasserstoffgemisch verwendet, wobei der Anteil des Methans mindestens 3 Vol% beträgt. Der Wasserstoff des Wasserstoffgases und/oder des Methans kann hierbei ganz oder teilweise, bei der Verwendung der Bauelemente in Fusionsanlagen dem Isotopenverhältnis des Plasmas entsprechend, durch Deuterium oder Tritium ersetzt sein.

Die zu belegende Oberfläche des Bauelementes kann sich während des Auftragens der Kohlenstoffschicht auf Raumtemperatur befinden, jedoch ist zur Erzeugung einer stabilen Kohlenstoffschicht, deren Dicke zweckmäßigerweise nicht mehr als 0,1 mm beträgt, die Oberfläche während der Erzeugung der Schicht bevorzugt auf einer höheren Temperatur (maximal 600 °C) zu halten.

Ausführungsbeispiel 1

Eine Probe aus Molybdän mit den Abmessungen 2 cm x 2 cm x 1 cm wurde in ein Vakuumgefäß gebracht, das von Wasserstoff unter einem Arbeitsdruck von $10^{-1}$ Pa durchströmt wurde und in dem eine Glimmentladung aufrechterhalten wurde. Die Probe war als Kathode geschaltet und wurde mittels einer separaten elektrischen Widerstandsheizung auf einer Temperatur von 300 °C gehalten.

Die sich auf der Oberfläche der Probe befindlichen Verunreinigungen Sauerstoff und Kohlenstoff wurden unter dem Zustrom der Wasserstoffionen mit einer Stromdichte von 10 $\mu$A/cm in Wasser bzw. Methan überführt und abgepumpt.

Nach einer halben Stunde wurde an Stelle des Wasserstoffs ein Wasserstoff-Methan-Gemisch (Methananteil 15 Vol%) eingelassen, die übrigen Bedingungen jedoch aufrechterhalten. Auf der Molybdänoberfläche schied sich dann eine amorphe, wasserstoffhaltige Kohlenstoffschicht ab, die nach einer Betriebsdauer von 5 Stunden auf der dem Plasma zugewandten Seite eine Dicke von 1000 Ångström aufwies.

Die so gefertigte Probe wurde durch Elektronenbeschuß einer Wärmelast von 120 MW/m² für einige 100 ms ausgesetzt.

Die auf die Probe aufgebrachte Kohlenstoffschicht überstand diese Belastung völlig unbeschadet.

Ausführungsbeispiel 2

Die Reinigung der Probe und der Auftrag der Kohlenstoffschicht wurde in gleicher Weise wie in Ausführungsbeispiel 1 beschrieben vorgenommen. An Stelle der Molybdänprobe wurde jedoch eine Probe aus Kupfer verwendet. Auch in diesem Falle überstand die Kohlenstoffschicht den in gleicher Weise wie in Ausführungsbeispiel 1 ausgeführten Belastungstest unbeschadet.

Ansprüche

1. Verfahren zur Herstellung von Bauelementen, bei dem nach Entfernung der Oberflächenverunreinigungen eine amorphe, wasserstoffhaltige Kohlenstoffschicht aufgetragen wird, auf die von außen durch elektromagnetische Strahlung oder auch Teilchenstrahlung Wärme zugeführt wird,
   **dadurch gekennzeichnet,**
   daß als Material des Bauelementes Molybdän, Wolfram, Kupfer, Aluminium oder Legierungen auf Basis dieser Metalle verwendet werden und die Kohlenstoffschicht als Schutz gegen kurzzeitige Bestrahlung mit einer Strahlungsleistung von bis zu 120 MW/m² vorgesehen ist.

2. Verfahren nach Anspruch 1,
   **dadurch gekennzeichnet,**
   daß die Teilchenstrahlung eine Protonenstrahlung ist.

3. Verfahren nach Anspruch 1 oder 2,
   **dadurch gekennzeichnet,**
   daß das Bauelement zur Reduktion der Oberflächenverunreinigungen bei einem Druck von $10^{-2}$ bis $10^2$ Pa und einer Temperatur von 100 °C bis 600 °C einem Wasserstoffatom- und/oder -ionen enthaltenden Wasserstoffstrom ausgesetzt wird, wobei aus dem Wasserstoffstrom Wasserstoffatome und/oder Wasserstoffionen durch Kontaktdissoziation an heißen Flächen oder mittels Glimmentladung oder durch Elektronenzyklotronresonanz gebildet werden, die mit der Oberfläche des Bauelementes in Kontakt gebracht werden, und wobei die gebildeten flüchtigen Verbindungen abgepumpt werden.

4. Verfahren nach Anspruch 3,
   **dadurch gekennzeichnet,**
   daß das Bauelement dem Wasserstoffstrom zur Reduktion der Oberflächenverunreinigungen bei einer Temperatur von etwa 300 °C ausgesetzt wird.

5. Verfahren nach einem der Ansprüche 1, 2 oder 3,
   **dadurch gekennzeichnet,**

daß das Bauelement zur Reduktion der Oberflächenverunreinigungen unter einem Druck von $10^{-2}$ bis $10^2$ Pa und einer Temperatur im Bereich von $10°$ C bis maximal $100°$ C einem Wasserstoffstrom mit einem Anteil von 0,1 bis 3 Vol% Methan ausgesetzt wird, wobei aus dem Gasstrom Wasserstoffatome und/oder Wasserstoffionen und Kohlenwasserstoffionen durch Kontaktdissoziation an heißen Flächen oder mittels Glimmentladung oder durch Elektronenzyklotronresonanz gebildet werden, die mit der zu reinigenden Oberfläche in Kontakt gebracht werden und wobei die gebildeten flüchtigen Verbindungen abgepumpt werden.

6. Verfahren nach Anspruch 4 oder 5,
**dadurch gekennzeichnet,**
daß die Stromdichte des auf die Oberfläche gerichteten Atom- bzw. Ionenstroms einige $\mu A/cm^2$ bis einige 100 $\mu A/cm^2$ beträgt.

7. Verfahren nach einem der Ansprüche 1 bis 6,
**dadurch gekennzeichnet,**
daß die Oberfläche des Bauelementes zur Auftragung der amorphen, wasserstoffhaltigen Kohlenstoffschicht unter einem Druck von $10^{-2}$ bis $10^2$ Pa einem Kohlenwasserstoffionen-Strom ausgesetzt wird, wobei die Kohlenwasserstoffionen in einer Glimmentladung oder durch Elektronenzyklotronresonanz erzeugt und auf die zu belegende Oberfläche des Bauelementes gerichtet werden.

8. Verfahren nach Anspruch 7,
**dadurch gekennzeichnet,**
daß die Dicke der Kohlenstoffschicht nicht mehr als 0,1 mm beträgt.

## Claims

1. Process for the production of structural elements, in which, after removal of surface impurities, an amorphous, hydrogen-containing carbon layer is applied, to which heat is supplied from the outside by electromagnetic radiation or else particulate radiation, characterised in that molybdenum, tungsten, copper, aluminium or alloys based on these metals are used as the material of the structural element and the carbon layer is provided as protection against short-term radiation having a radiation power of up to 120 MW/m².

2. Process according to Claim 1, characterised in that the particulate radiation is a proton radiation.

3. Process according to Claim 1 or 2, characterised in that the structural element is, for the reduction of surface impurities, subjected to a hydrogen stream containing hydrogen atoms and/or hydrogen ions at a pressure from $10^{-2}$ to $10^2$ Pa and at a temperature from $100°$ C to $600°$ C, hydrogen atoms and/or hydrogen ions being formed from the hydrogen stream by contact dissociation on hot surfaces or by means of a glow discharge or by electron cyclotron resonance, which atoms and/or ions are contacted with the surface of the structural element, the volatile compounds formed being pumped off.

4. Process according to Claim 3, characterised in that the structural element is, for reducing the surface impurities, subjected to the hydrogen stream at a temperature of about $300°$ C.

5. Process according to one of Claims 1, 2 or 3, characterised in that the structural element is, for reducing the surface impurities, subjected to a hydrogen stream containing 0.1 to 3% by volume of methane under a pressure from $10^{-2}$ to $10^2$ Pa and at a temperature in the range from $10°$ C up to at most $100°$ C, hydrogen atoms and/or hydrogen ions and hydrocarbon ions being formed from the gas stream by contact dissociation on hot surfaces or by means of a glow discharge or by electron cyclotron resonance, which atoms and/or ions are contacted with the surface which is to be purified, and the volatile compounds formed being pumped off.

6. Process according to Claim 4 or 5, characterised in that the current density of the atom current or ion current directed upon the surface amounts to a few $\mu A/cm^2$ to several 100 $\mu A/cm^2$.

7. Process according to one of Claims 1 to 6, characterised in that the surface of the structural element is, for applying the amorphous, hydrogen-containing carbon layer, subjected to a hydrocarbon ion stream under a pressure from $10^{-2}$ to $10^2$ Pa, the hydrocarbon ions being generated in a glow discharge or by electron cyclotron resonance and being directed upon the structural element surface which is to be covered.

8. Process according to Claim 7, characterised in that the thickness of the carbon layer is not more than 0.1 mm.

## Revendications

1. Procédé de fabrication d'éléments de construction, qui consiste à déposer, après élimination des impuretés superficielles, une couche de carbone amorphe qui contient de l'hydrogène et à laquelle de la chaleur est apportée de l'extérieur par un rayonnement électromagnétique ou par un rayonnement de particules,

caractérisé,

en ce qu'il consiste à utiliser, comme matériau de l'élément de construction, du molybdène, du tungstène, du cuivre, de l'aluminium ou des alliages à base de ces métaux, et à prévoir la couche de carbone comme protection vis-à-vis d'un rayonnement de brève durée d'une puissance rayonnée allant jusqu'à 120 $MW/m^2$.

2. Procédé suivant la revendication 1,

caractérisé,

en ce que le rayonnement de particules est un rayonnement de protons.

3. Procédé suivant la revendication 1 ou 2,

caractérisé,

en ce qu'il consiste à soumettre l'élément de construction, pour réduire les impuretés superficielles, à un courant d'hydrogène contenant des atomes d'hydrogène et/ou des ions d'hydrogène, sous une pression de $10^{-2}$ à $10^2$ Pa et à une température de 100°C à 600°C, des atomes d'hydrogène et/ou des ions d'hydrogène étant formés à partir du courant d'hydrogène par dissociation par contact sur des surfaces chaudes ou au moyen d'une décharge luminescente ou par résonance cyclotron électronique et étant mis en contact avec la surface de l'élément de construction, les composés volatils formés étant évacués par pompage.

4. Procédé suivant la revendication 3,

caractérisé,

en ce qu'il consiste à soumettre l'élément de construction au courant d'hydrogène pour la réduction des impuretés superficielles à une température de 300°C environ.

5. Procédé suivant l'une des revendications 1, 2 ou 3,

caractérisé,

en ce qu'il consiste à soumettre l'élément de construction, pour réduire les impuretés superficielles, à un courant d'hydrogène ayant une proportion de méthane de 0,1 à 3 % en volume, sous une pression de $10^{-2}$ à $10^2$ Pa et à une température de l'ordre de 10°C jusqu'à un maximum de 100°C, des atomes d'hydrogène et/ou des ions d'hydrogène et des ions d'hydrocarbure provenant du courant gazeux étant formés par dissociation par contact sur des surfaces chaudes ou au moyen d'une décharge luminescente ou par résonance cyclotron électronique et venant en contact avec les surfaces à nettoyer, les composés volatils formés étant évacués par pompage.

6. Procédé suivant la revendication 4 ou 5,

caractérisé,

en ce que la densité de courant électrique du courant d'atomes et d'ions dirigé sur la surface est comprise entre quelques $\mu A/cm^2$ et quelques 100 $\mu A/cm^2$.

7. Procédé suivant l'une des revendications 1 à 6,

caractérisé,

en ce qu'il consiste à soumettre la surface de l'élément de construction, pour le dépôt de la couche de carbone amorphe et contenant de l'hydrogène, à un courant d'ions d'hydrocarbure sous une pression de $10^{-2}$ à $10^2$ Pa, les ions d'hydrocarbure étant produits dans une décharge luminescente ou à résonance cyclotron électronique et étant dirigés sur la surface de l'élément de construction à revêtir.

8. Procédé suivant la revendication 7,

caractérisé,

en ce que l'épaisseur de la couche de carbone n'est pas supérieure à 0,1 mm.